Europäisches Patentamt

European Patent Office

Office européen des brevets

(11) Veröffentlichungsnummer: **0 350 662**
**A2**

## (12) EUROPÄISCHE PATENTANMELDUNG

(21) Anmeldenummer: **89111142.9**

(22) Anmeldetag: **20.06.89**

(51) Int. Cl.⁴: **G01R 31/12**

(30) Priorität: **09.07.88 DE 3823389**

(43) Veröffentlichungstag der Anmeldung:
**17.01.90 Patentblatt 90/03**

(84) Benannte Vertragsstaaten:
**AT BE CH ES FR GB IT LI LU NL SE**

(71) Anmelder: **OBO Bettermann OHG**
**Hüingser Ring 52**
**D-5750 Menden 2(DE)**

(72) Erfinder: **Jordan, Ernst-Günther, Ing. grad.**
**Oberm Rolande 98**
**D-5750 Menden 2(DE)**

(74) Vertreter: **Köchling, Conrad, Dipl.-Ing. et al**
**Patentanwälte, Dipl.-Ing. Conrad Köchling**
**Dipl.-Ing. Conrad-Joachim Köchling Fleyer**
**Strasse 135**
**D-5800 Hagen 1(DE)**

(54) **Verfahren und Vorrichtung zur Erfassung von Strossströmen an Blitzableitern, Überspannungsableitern oder dergleichen.**

(57) Um ein Verfahren zur Erfassung von Stoßströmen an Blitzableitern, Überspannungsableitern oder dergleichen, zu schaffen, mittels dessen auf kostengünstige Art und Weise sehr leicht der Nachweis zu führen ist, daß ein Überspannungsereignis stattgefunden hat, wird vorgeschlagen, daß auf einem magnetisierbaren Datenträger Daten abgelegt werden, der Datenträger in dem Bereich eines im Ereignisfall stoßstrom-durchflossenen elektrischen Leiters angeordnet wird, in welchem sich im Ereignisfall ein Magnetfeld aufbaut, die Daten periodisch oder aperiodisch abgelesen werden und aus der Menge und Verteilung der auf dem Datenträger verbliebenen Daten das Faktum eines Ereignisfalles sowie die Intensität des stärksten Ereignisfalles ermittelt wird.

*Fig.1*

## Verfahren und Vorrichtung zur Erfassung von Stoßströmen an Blitzableitern, Überspannungsableitern oder dergleichen

Die Erfindung betrifft ein Verfahren und eine Vorrichtung zur Erfassung von Stoßströmen an Blitzableitern, Überspannungsableitern oder dergleichen.

Blitz- und Überspannungsableiter sind äußerst wirksame Mittel um Leben und Sachgüter zu schützen.

Der Nachweis aber, ob derartige Ereignisse tatsächlich stattgefunden bzw. die entsprechenden Vorrichtungen und Anlagen gewirkt, also geschützt haben, ist in der Regel nicht zu führen. Es gibt zwar Meßeinrichtungen, wie Transientenrecorder oder Blitzzähler, die zu diesem Zwecke brauchbar wären, jedoch sind diese derart kostenspielig, daß solche Überwachungseinrichtungen nicht an jeder Blitzschutzanlage oder an jedem Überspannungsableiter wirtschaftlich sinnvoll einsetzbar sind.

Aufgabe vorliegender Erfindung ist die Schaffung eines Verfahrens und einer Vorrichtung, mittels dessen bzw. derer auf kostengünstige Art und Weise sehr leicht der Nachweis zu führen ist, daß ein Überspannungsereignis stattgefunden hat.

Zur prinzipiellen Lösung dieser Aufgabe wird verfahrensmäßig vorgeschlagen, daß auf einem magnetisierbaren Datenträger Daten abgelegt werden, der Datenträger in dem Bereich eines im Ereignisfalle stoßstrom-durchflossenen elektrischen Leiters angeordnet wird, in welchem sich im Ereignisfall ein Magnetfeld aufbaut, die Daten periodisch oder aperiodisch abgelesen werden und aus der Menge und Verteilung der auf dem Datenträger verbliebenen Daten das Faktum eines Ereignisfalles sowie die Intensität des stärksten Ereignisfalles ermittelt wird.

Durch diese Verfahrensweise ist es möglich, ein Überspannungsereignis festzustellen.

Es ist zwar nicht möglich, die Anzahl von Ereignissen festzustellen, jedoch ist zumindest das der Größenordnung nach stärkste Ereignis erfaßbar.

Damit kann nicht nur der Beweis geführt werden, daß ein Ableiter über Jahre hinaus seine Aufgabe erfüllt hat, sondern es können auch Kontrollen über Stromverteilungen (Stoßstrom) und andere Untersuchungen durchgeführt werden.

Bei Einsatz des erfindungsgemäßen Verfahrens wird der Effekt ausgenutzt, daß sich im Ereignisfall um den vom Stoßstrom durchflossenen elektrischen Leiter ein Magnetfeld aufbaut, welches dazu benutzt wird, die auf dem magnetisierbaren Datenträger abgelegten Daten mindestens teilweise, je nach Stärke des Stoßstromes, zu löschen. Durch das Ablesen der noch auf dem Datenträger erhaltenen Daten sowie der Feststellung der Verteilung der auf dem Datenträger verbliebenen Daten kann ermittelt werden, ob überhaupt ein Überspannungsereignis stattgefunden hat und welche relative Größenordnung das stärkste Überspannungsereignis gehabt hat.

Vorrichtungsmäßig löst die Erfindung die Aufgabe dadurch, daß ein mit Speicherdaten versehener magnetisierbarer Datenträger in einer räumlichen Zuordnung zu einem von Stoßströmen durchströmbaren elektrischen Leiter angeordnet ist, so daß mindestens einige mit Daten versehene Zonen des Datenträgers im Falle eines Stoßstromes in dem um den Leiter entstehenden Magnetfeld angeordnet sind.

Beispielsweise kann ein Magnetbandträger (ein Band, eine Karte, ein Etikett oder eine Diskette) in definierter Lage zu einem vom Stoßstrom durchflossenen elektrischen Leiter angeordnet werden. Das Magnetband trägt analog oder digital gespeicherte Signale oder Daten, die durch das vom Stoßstrom erzeugte Magnetfeld teilweise oder auch vollständig gelöscht oder geändert werden.

Im Normalfall fließt weder über Blitzschutzanlagen noch über Überspannungsableiter ein nennenswerter Strom, so daß die auf dem Datenträger befindlichen Daten erhalten bleiben, bis ein solches Ereignis eintritt, welches einen Stoßstrom auslöst.

Je intensiver der Stoßstrom, desto stärker ist das entstehende Magnetfeld.

Entsprechend mehr Informationen werden deshalb von dem magnetisierten Datenträger gelöscht.

Es bleibt also zwangsläufig das stärkste stattgefundene Ereignis seiner Größenordnung und seiner Tatsache nach erhalten. Ausgewertet und gemessen kann mit geeigneten Lesegeräten werden.

In Weiterbildung kann die Vorrichtung selbstverständlich so gestaltet werden, daß die Einheit aus Leiter und Magnetband gegenüber Fremdfeldern abgeschirmt ist, so daß eine ungewollte Beeinflussung unterbunden ist.

Weitere vorteilhafte Merkmale sind in den Unteransprüchen bezeichnet.

Ausführungsbeispiele der Erfindung sind in der Zeichnung dargestellt und im folgenden näher beschrieben.

Es zeigt:

Fig. 1 einen prinzipiellen Aufbau einer erfindungsgemäßen Erfassungsvorrichtung;

Fig. 2 symbolische Speicherfunktionen;

Fig. 3 ein Ausführungsbeispiel zur Anwendung bei einem Überspannungsableiter;

Fig. 4 ein Ausführungsbeispiel zur Überwachung eines Blitzableiterdrahtes;

Fig. 5 eine Variante hierzu.

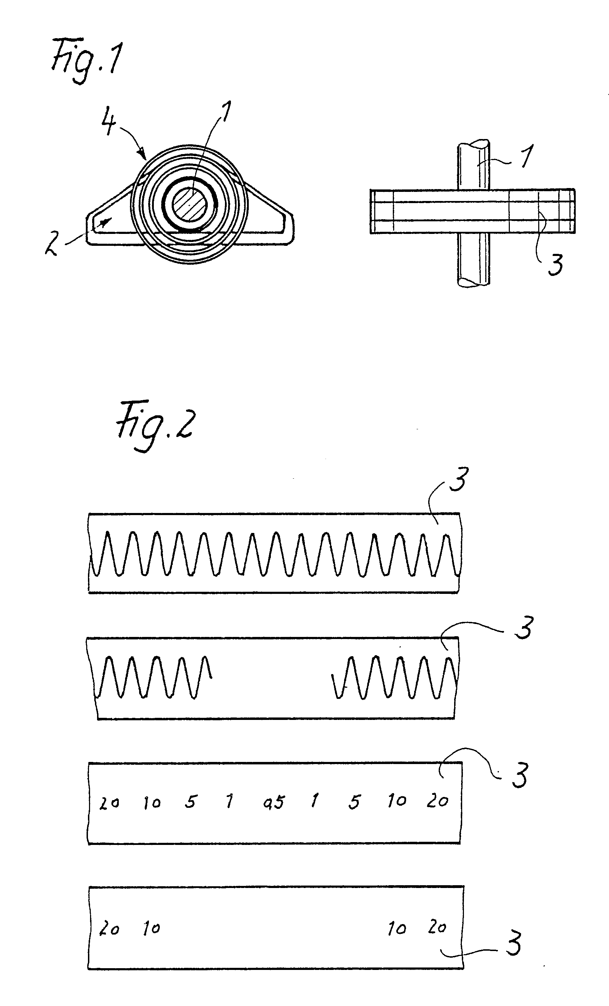

Sämtliche Ausführungsbeispiele sind streng schematisiert dargestellt. Im Ausführungsbeispiel gemäß Figur 1 ist der prinzipielle Aufbau gezeigt.

Ein elektrischer Leiter 1 als Bestandteil einer Überspannungseinrichtung oder einer Blitzschutzeinrichtung ist mit einem Träger 2 versehen, welcher einen magnetisierbaren Datenträger in Form eines Bandes 3 trägt.
Der Datenträger ist mit Daten belegt.
Tritt nun ein Überspannungsereignis ein, so wird der Leiter 1 von einem Stoßstrom durchflossen, was zur Folge hat, daß sich um den Leiter 1 ein Magnetfeld 4 beispielsweise wie in Figur 1 gezeigt ausbildet.

Im Bereich des Magnetfeldes werden die auf dem Datenträger 3 befindlichen Daten gelöscht oder verändert und lediglich in dem außerhalb des Magnetfeldes befindlichen Bereich bleiben die eingelesenen Daten auf dem Datenträger 3 erhalten.

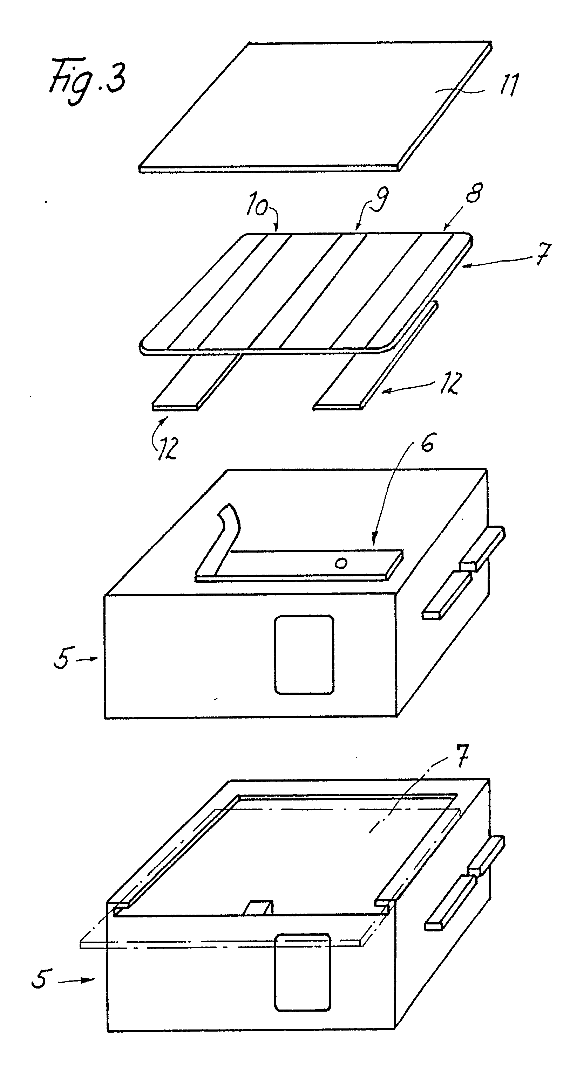

In Figur 2 sind symbolische Daten auf dem Magnetträger 3 bzw. der Magnetspule des Magnetträgers 3 angedeutet.

In der Zeichnungsfigur 2 oben ist beispielsweise ein Tonsignal auf der Magnetspur eines Magnetträgers aufgebracht.

In der darunter befindlichen Figur ist nach einem erfolgten Stoßstrom ein Teilbereich des Tonsignales gelöscht, was Aufschluß darüber gibt, daß ein Ereignis stattgefunden hat.

In der Zeichnung darunter sind digitale Daten auf dem Datenträger angeordnet, die gleichzeitig als Maßstab für die Stromstärke des Stoßstromes anzusehen sind. In der Zeichnung darunter ist die Situation nach einem erfolgten Stoßstrom angegeben, wobei im Beispiel ein Stoßstrom der Größenordnung unterhalb 10 kA stattgefunden hat.

In der Zeichnungsfigur 3 ist die Erfindung anhand eines Stoßstromindikators bei Überspannungsableitern dargestellt. Im Inneren des Überspannungsableiters 5 ist ein Strompfad 6 in Form eines Sicherungsstreifens bzw. einer auf definiertem Abstand angeordneten Zuleitung vorgesehen.

Im Überspannungsfall erzeugt der Strompfad 6 das entsprechende Magnetfeld. Auf der Außenseite des Ableiters kann ein Etikett oder eine Plastikkarte 7 mit Magnetspuren 8,9,10 angebracht werden.

Diese Magnetspuren sind zunächst durchgehend mit Informationen bzw. Signalen gefüllt. Je nach Intensität des Ableiterstromes werden die Signale der freiliegenden Magnetspur 9 gelöscht oder geändert. Dieser Zustand kann von außen jederzeit mit einem geeigneten Lesegerät erfaßt werden. Neben der sogenannten Ereignisspur 9 können auch andere Spuren angebracht sein, zum Beispiel eine geschirmte (geschützte) Vergleichs- oder Referenzspur 8 zur Kontrolle nämlich, ob die Löschung tatsächlich von innen erfolgte.

Eine weitere Datenspur kann Herstellerdaten, wie Fertigungsdatum, kontrolliert von Betriebsspannung, Varistorspannung bei 1 mA (Kennlinie) und anderes enthalten.
Gegebenenfalls können alle Informationen durch eine übergeklebte metallische Folie 11 zusätzlich von außen geschützt werden, welche Folie im Kontrollfalle (Ablesevorgang mittels eines geeigneten Gerätes) einfach abgezogen wird. Damit kann dem Überspannungsableiter sozusagen der komplette Lebenslauf mitgeliefert werden. Ereignisse und Veränderungen während der Einsatzdauer können ohne weiteres nachvollzogen werden.

Zur Abschirmung der Referenzspur 8 und der die Herstelldaten erfassenden Spur 10 können Abschirmfolien 12 oder auch Metallbedampfungen an diesen Stellen vorgesehen sein.

In der Zeichnung unten ist eine Ausführungsform eines Überspannungsableiters dargestellt, bei welchem die Plastikkarte 7 in einen Einschub eingeschoben werden kann und so lagegesichert gehalten ist.

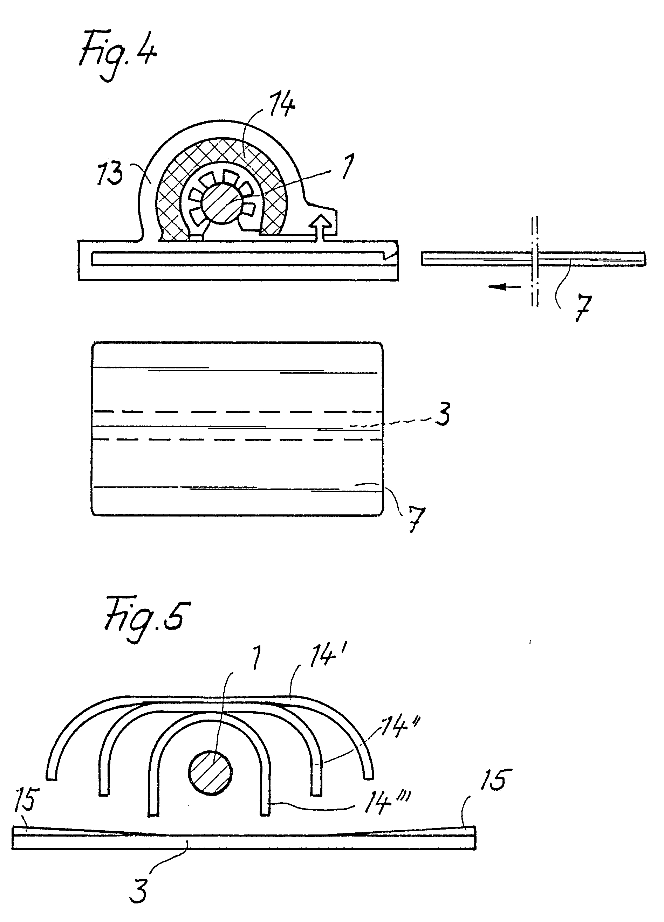

Beim Ausführungsbeispiel nach Figur 4 ist das Erfindungsprinzip anhand eines Stoßstromindikators zur Überwachung von Blitzströmen gezeigt. Es handelt sich auch hierbei um eine Vorrichtung, die kurzzeitige Stoßströme aufzeichnen kann. Diese Vorrichtung 13 wird um einen elektrischen Leiter 1 (Ableiter, zum Beispiel einer Blitzschutzanlage) angeordnet und lagegesichert aufgeclipst. Sie besteht aus der eigentlichen Haltevorrichtung, wobei in dieser Haltevorrichtung noch ein Ferrit- oder Eisenkern 14 integriert ist, der zur gewünschten Steuerung des Magnetflusses dient. Zusätzlich ist unterhalb der Vorrichtung ein Einschubpfad für eine Plastikkarte mit Magnetspuren vorgesehen. Die auf der Karte 7 vorgesehene rückseitige Magnetspur 3 ist in Abbildung 4 unten ersichtlich.

Auf der Karte können zusätzlich Herstellerangaben und Prüfdaten angegeben sein. Diese Karte kann nach einer Überwachungsperiode der Blitzschutzanlage entnommen werden oder auch in der Anlage selbst abgelesen werden.

Wie aus Figur 5 ersichtlich, kann die Feldstärke durch gezielte Luftspaltbildung zwischen Magnetspur 3 und Ferritkern 14', 14'', 14''' beeinflußt werden.

Es können auch andere Dämpfungsmaßnahmen vorgesehen sein.
So kann beispielsweise auf der Magnetspur 3 eine Dämpfungsbeschichtung 15 in den Randbereichen vorgesehen sein.

Die Erfindung ist nicht auf die Ausführungsbeispiele beschränkt, sondern im Rahmen der Offenbarung vielfach variabel.

**Ansprüche**

1. Verfahren zur Erfassung von Stoßströmen an Blitzableitern, Überspannungsableitern oder dergleichen, **dadurch gekennzeichnet,** daß auf einem magnetisierbaren Datenträger Daten abgelegt werden, der Datenträger in dem Bereich eines im Ereignisfall stoßstrom-durchflossenen elektrischen Leiters angeordnet wird, in welchem sich im Ereignisfall ein Magnetfeld aufbaut, die Daten periodisch oder aperiodisch abgelesen werden und aus der Menge und Verteilung der auf dem Datenträger verbliebenen Daten das Faktum eines Ereignisfalles sowie die Intensität des stärksten Ereignisfalles ermittelt wird.

2. Vorrichtung zur Durchführung des Verfahrens nach Anspruch 1, **dadurch gekennzeichnet,** daß ein mit Speicherdaten versehener magnetisierbarer Datenträger (3) in einer räumlichen Zuordnung zu einem von Stoßströmen durchströmbaren elektrischen Leiter (1) angeordnet ist, so daß mindestens einige mit Daten versehene Zonen des Datenträgers (3) im Falle eines Stoßstromes in dem um den Leiter (1) entstehenden Magnetfeld angeordnet sind.

3. Vorrichtung nach Anspruch 2, **dadurch gekennzeichnet,** daß der Datenträger (3) und der den Datenträger (3) beeinflussende Bereich des Leiters (1) gegen Fremdfelder abgeschirmt sind.

4. Vorrichtung nach Anspruch 2 oder 3, **dadurch gekennzeichnet,** daß auf dem Leiter (1) ein Träger (2,13) angeordnet ist, welcher den Datenträger (3,7) haltert.

5. Vorrichtung nach einem der Ansprüche 2 bis 4, **dadurch gekennzeichnet,** daß der Datenträger (3,7) sich quer zum Längsverlauf des Leiters (1) erstreckend angeordnet ist.

6. Vorrichtung nach einem der Ansprüche 2 bis 5, **dadurch gekennzeichnet,** daß der Datenträger (3,7) mehrere parallel zueinander angeordnete Magnetspuren (z.B. 8,9,10) aufweist, deren eine als Referenzspur ausgebildet ist und gegenüber dem Leiter (1) abgeschirmt ist, und deren eine weitere als Ereignisspur ausgebildet ist, wobei beide Spuren gleiche Dateninhalte speichern.

7. Vorrichtung nach einem der Ansprüche 2 bis 6, **dadurch gekennzeichnet,** daß der Datenträger (3,7) auf eine formstabile Karte aufgebracht ist, die in eine im möglichen Magnetfeld des Leiters (1) angeordnete Halterung einschiebbar ist, welche Bestandteil eines Überspannungsableitergehäuses (5) ist.

8. Vorrichtung nach einem der Ansprüche 2 bis 7, **dadurch gekennzeichnet,** daß die Halterung (13) aus einem um den Leiter (1) klemmbaren Gehäuse besteht.

9. Vorrichtung nach einem der Ansprüche 2 bis 8, **dadurch gekennzeichnet,** daß in dem Gehäuse ein Ferritkern (14) angeordnet ist, mittels dessen das Magnetfeld zum Datenträger (7) hin ausrichtbar ist.

*Fig.1*

*Fig.2*

Fig.3

EP 0 350 662 A2

*Fig.4*

*Fig.5*